**Europäisches Patentamt**

**European Patent Office**

**Office européen des brevets**

(19)

(11) Veröffentlichungsnummer: **0 081 668**
**B1**

(12) # EUROPÄISCHE PATENTSCHRIFT

(45) Veröffentlichungstag der Patentschrift:
**25.01.89**

(51) Int. Cl.⁴: **H 05 K 13/00**

(21) Anmeldenummer: **82110153.2**

(22) Anmeldetag: **04.11.82**

(54) Vorrichtung zum Umgurten elektrischer Bauelemente.

(30) Priorität: **10.12.81 DE 8135962 U**

(43) Veröffentlichungstag der Anmeldung:
**22.06.83 Patentblatt 83/25**

(45) Bekanntmachung des Hinweises auf die Patenterteilung:
**25.01.89 Patentblatt 89/4**

(84) Benannte Vertragsstaaten:
**AT BE CH DE FR GB IT LI LU NL SE**

(56) Entgegenhaltungen:
**DE-A-2 910 633**
**DE-U-8 135 962**
**FR-A-2 365 274**
**US-A-3 945 100**

(73) Patentinhaber: **Sillner, Georg, Buchenstrasse 23,
D-8411 Zeitlarn (DE)**

(72) Erfinder: **Sillner, Georg, Buchenstrasse 23, D-8411
Zeitlarn (DE)**

(74) Vertreter: **Graf, Helmut, Dipl.- Ing., Greflinger
Strasse 7 Postfach 382, D-8400 Regensburg (DE)**

EP 0 081 668 B1

## Beschreibung

Die Erfindung bezieht sich auf eine Vorrichtung zum Umgurten von axial gegurteten elektrischen Bauelementen in quasi-radial gegurtete Bauelemente.

Es ist heute allgemein üblich, daß elektrische Bauelemente, wie beispielsweise Widerstände, Kondensatoren, oder Dioden, die zwei Anschlußdrähte aufweisen und bei denen die beiden Anschlußdrähte axial von dem jeweiligen Bauelement bzw. von dem jeweiligen Bauelementkörper bzw. Gehäuse wegstehen, vom Bauelementehersteller aufgegurtet derart ausgeliefert werden, daß eine Vielzahl von Bauelementen an zwei parallelen Streifen aus Papier oder anderem geeigneten Material mit den Enden ihrer beiden Anschlußdrähte gehalten sind. Die einzelnen Bauelemente liegen dann einschließlich ihrer Anschlußdrähte leitersprossenähnlich zu den beiden, die Gurtung bildenden Streifen. Derart aufgegurtete Bauelemente werden im folgenden als "axial gegurtete Bauelemente" bezeichnet.

Insbesondere für eine automatische Bestückung von Leiterplatten (z. B. gedruckte Schaltungen) ist es in der Regel erforderlich, daß die elektrischen Bauelemente an einem einzigen Streifen bzw. an einem einzigen Gurt befestigt bzw. aufgegurtet sind, und zwar in der Weise, daß die beiden Anschlußdrähte jedes Bauelementes mit ihren freien Enden in ein und dieselbe Richtung weisen, und daß die Bauelemente mit diesen freien Enden an einer Längsseite des einzigen Gurtes bzw. Streifens befestigt sind und ansonsten über diese Längsseite vorstehen. Derart aufgegurtete Bauelemente werden im folgenden als "quasi-radial gegurtete Bauelemente" bezeichnet, siehe beispielsweise die FR-A-2 365 274 und die US-A-3 945 100.

Der Erfindung liegt die Aufgabe zugrunde, eine Vorrichtung aufzuzeigen, mit der das Umgurten von axial gegurteten Bauelementen in quasi-radial gegurtete Bauelemente mit einfachen Mitteln möglich ist, und die darüber hinaus auch sicherstellt, daß die umgegurteten Bauelemente sowohl hinsichtlich ihrer Positionierung an dem einzigen Gurt als auch hinsichtlich der Formgebung ihrer Anschlußdrähte die geforderten engen Toleranzgrenzen voll und ganz einhalten, so daß die umgegurteten Bauelemente tatsächlich auch für die automatische Bestückung von elektrischen Schaltkreisen geeignet sind.

Zur Lösung dieser Aufgabe ist eine Vorrichtung der eingangs geschilderten Art erfindungsgemäß so ausgebildet, daß an einem Maschinengestell eine erste, ortsfest angeordnete Arbeitsstation zum Zuführen der axial gegurteten Bauelemente und zum Umbiegen wenigstens eines Anschlußdrahtes dieser Bauelemente vorgesehen ist, an der (Arbeitsstation) ein Transportelement, vorzugsweise ein Dreh- bzw. Transportteller schrittweise vorbeibewegt wird, welches bzw. welcher Aufnahmen für die Bauelemente aufweist, daß die erste Arbeitsstation einen vorzugsweise nur an einem Ende befestigten bzw. gehaltenen Biegedorn (ersten Stift) aufweist, dessen Achse in etwa parallel zu einer, vorzugsweise horizontalen und quer zur Bewegungsrichtung des Transportelementes bzw. der Aufnahmen verlaufenden Raumachse liegt und der vorzugsweise mit wenigstens einem Teil seiner Umfangsfläche eine Fortsetzung einer Fläche der Aufnahme bildet, daß an der esten Arbeitsstation um eine Achse in etwa parallel zu der erwähnten Raumachse ein Träger schwenkbar bzw. drehbar gelagert ist, der an einer dem Transportelement zugewendeten Seite ein vorstehendes und gegenüber dem ersten Stift bzw. dem Biegedorn versetztes Biegeelement trägt, welches eine Gegenfläche zum Biegen bildet, daß an der ersten Arbeitsstation ein Einleger vorgesehen ist, welcher eine dem Transportelement zugewendete Anlagefläche für die Bauelemente bildet, über die (Anlagefläche) der Biegedorn mit seinem einen Ende vorsteht, daß der Einleger (39) in Richtung der erwähnten Raumachse aus einer, dem Transportelement entfernt liegenden Ruhestellung in eine dem Transportelement bzw. den dortigen Aufnahmen benachbart liegende Arbeitsstellung verschiebbar ist, und daß an der ersten Arbeitsstation Mittel, z. B. Messerelemente zum Abtrennen der axial gegurteten Bauelemente von der Gurtung vorgesehen sind.

Bei der erfindungsgemäßen Vorrichtung wird in der ersten Arbeitsstation mit Hilfe der erwähnten Mittel zum Abtrennen der Bauelemente zumindest zunächst ein Anschlußdraht jedes Bauelementes von der Gurtung abgetrennt und dann dieser Anschlußdraht mit Hilfe des Biegeelementes um den Biegedorn umgebogen.

Nach erfolgter Abtrennung auch des zweiten Anschlußdrahtes von der entsprechenden Gurtung wird dann mit Hilfe des Einlegers bzw. mit Hilfe der Anlagefläche dieses Einlegers das Bauelement in eine bereitstehende Aufnahme des Transportelementes seitlich hineingeschoben, wobei das betreffende Bauelement bei diesem Einschieben mit seinem hakenartig umgebogenen Anschlußdraht an dem ersten Stift bzw. an dem Biegedorn, der sich vorzugsweise in horizontaler Richtung erstreckt, hängend und gleitend geführt ist, und zwar solange, bis das betreffende Bauelement seitlich in eine bereitstehende Aufnahme des Transportelementes gelangt ist.

Bei einer bevorzugten Ausführungsform der Vorrichtung ist der das Biegeelement aufweisende Träger an einem ersten Schlitten befestigt, der in Richtung der erwähnten Raumachse verschiebbar ist, und zwar aus einer Ruhestellung, in der der Träger einen größeren Abstand vom Transportelement aufweist, in eine Arbeitsstellung, in der das oben erwähnte Umbiegen des einen Anschlußdrahtes erfolgt und in der der Träger einen geringeren Abstand von dem Transportelement besitzt. Der Einleger ist dabei vorzugsweise an einem zweiten, ebenfalls in Richtung der erwähnten Raumachse verschiebbaren Schlitten befestigt.

Das Transportelement besitzt an jeder Aufnahme vorzugsweise ein seitlich wegstehendes Halteelement mit einer Fläche, die mit derjenigen Fläche des Biegedorns fluchtet bzw. niveaugleich liegt, auf der das Bauelement mit seinem hakenförmig umgebogenen Anschlußdraht hängend bzw. gleitend geführt ist. Sowohl das Umbiegen des einen Anschlußdrahtes als auch das Überführen des betreffenden Bauelementes nach dem Umbiegen in die Aufnahme des Transportelementes erfolgt somit bei der erfindungsgemäßen Vorrichtung mit einfachen Mitteln, und vor allem auch ohne daß ein Drehen oder Kippen des betreffenden Bauelementes erforderlich wäre. Der gleiche Dorn oder Stift, der zum Umbiegen verwendet wird, dient zur Führung des Bauelementes bei der Übergabe an das Transportelement. Außerdem kann bei der erfindungsgemäßen Vorrichtung das Umbiegen des einen Anschlußdrahtes jedes Bauelementes in der gleichen Ebene erfolgen, in der dieser Anschlußdraht beim Zuführen des betreffenden Bauelementes an die erste Arbeitsstation liegt.

Das Transportelement wird bei der erfindungsgemäßen Vorrichtung vorzugsweise von einem Dreh- bzw. Transportteller gebildet, der bevorzugt um eine vertikale Achse schrittweise drehbar ist und der an seinem Außenumfang die erwähnten Aufnahmen (vorzugsweise mit den Halteelementen) aufweist.

Bei einer bevorzugten Ausführungsform der erfindungsgemäßen Vorrichtung ist am Maschinengestell der ersten Arbeitsstation eine zweite Arbeitsstation nachgeschaltet, in der die Anschlußdrähte der im Transportelement gehaltenen Bauelemente in einer vorgegebenen Weise gebogen bzw. geformt werden. Diese zweite Arbeitsstation besitzt dann beispielsweise einen dritten Schieber, der quer zur dortigen Bewegungsrichtung des Transportelementes aus einer Ruhestellung in eine Arbeitsstellung bewegbar ist, sowie wenigstens ein Biegewerkzeug, z. B. ein Zangenelement, mit einer z. B. von einem Vorsprung gebildeten Formfläche, die in Richtung quer zur Verschiebungsrichtung des dritten Schiebers bewegbar ist. Mit dieser Formfläche kann dann beispielsweise unter gleichzeitiger Verwendung von Anlageflächen bzw. Gegenflächen am Transportelement und/oder an der zweiten Arbeitsstation ein Anschlußdraht in der gewünschten Weise z. B. S-förmig abgebogen bzw. abgewinkelt werden oder aber mit einer Auskragung versehen werden.

Weiterbildungen der Erfindung sind Gegenstand der Unteransprüche.

Die Erfindung wird im folgenden anhand der Figuren an einem Ausführungsbeispiel näher erläutert. Es zeigen:

Fig. 1 in schematischer Darstellung und in Draufsicht eine erfindungsgemäße Vorrichtung;

Fig. 2 in Seitenansicht die erste Arbeitsstation zum Abtrennen der axial gegurteten Bauelemente, zum Umbiegen jeweils eines Anschlußdrahtes dieser Bauelemente sowie zum Einlegen der Bauelemente in den Transportteller, zusammen mit einer Teildarstellung dieses Transporttellers;

Fig. 3 eine Darstellung der ersten Arbeitsstation gemäß fig. 2, von dem Transportteller her gesehen;

Fig. 4 einen Schnitt entsprechend der Linie II - II der Fig. 1;

Fig. 5 einen Schnitt entsprechend der Linie III - III der Fig. 3;

Fig. 6 in Einzeldarstellung und in Seitenansicht den Einleger der ersten Arbeitsstation;

Fig. 7 in Draufsicht den Einleger der ersten Arbeitsstation;

Fig. 8 im Längsschnitt die zweite Arbeitsstation zum Formen der Anschlußdrähte der Bauelemente, zusammen mit einer Teildarstellung des Transporttellers;

Fig. 9 in Draufsicht die in der zweiten Arbeitsstation verwendete Zangenanordnung;

Fig. 10 in vergrößerter Darstellung ein an einem Stift des Transporttellers gehaltenes Bauelement zusammen mit den teilweise am Transportteller sowie teilweise von der zweiten Arbeitsstation gebildeten Anlage- bzw. Formflächen, wobei letztere in der Fig. 10 durch eine Schraffur hervorgehoben sind;

Fig. 11 mehrere Bauelemente mit der Gurtung, wie sie der Vorrichtung zugeführt werden;

Fig. 12 die gleichen Bauelemente nach erfolgter Umgurtung in der Vorrichtung.

In den Figuren sind 1 elektrische Bauelemente, z. B. elektrische Widerstände, die der Vorrichtung in einer Gurtung entsprechend der Fig. 11 zugeführt werden, d.h. die axial von den Bauelementen 1 wegstehenden Anschlußdrähte 2 und 3 dieser Bauelemente sind an ihren Enden jeweils an einem von zwei parallel zueinander verlaufenden Streifen 4 beispielsweise aus Papier derart befestigt, daß die Bauelemente 1 mit ihren Anschlußdrähten 2 und 3 sprossenartig zu den beiden, die Gurtung bildenden Streifen 4 liegen.

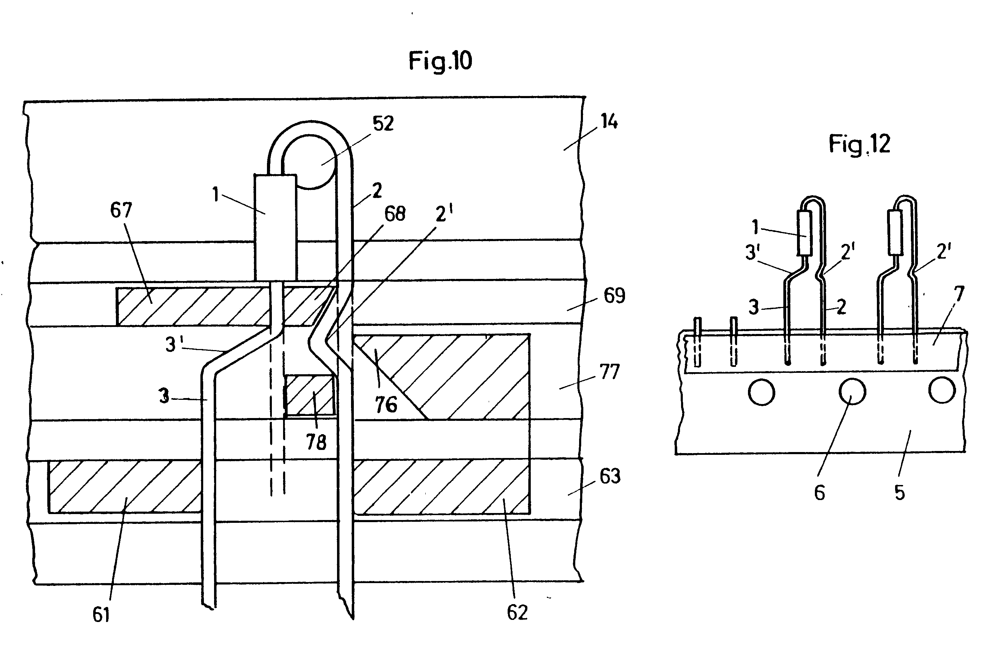

Mit Hilfe der in den Figuren dargestellten Vorrichtung sollen diese axial gegurteten Bauelemente 1 so umgegurtet werden, daß sie entprechend der Fig. 12 mit beiden Anschlußdrähten 2 und 3 an einer Längsseite eines einzigen Gurtes bzw. Streifens 5, vorzugsweise ebenfalls aus Papier, derart gehalten sind, daß diese Bauelemente 1 und deren Anschlußdrähte 2 und 3 in einer genau vorgegebenen Lage sowie in einem genau vorgegebenen gegenseitigen Abstand von der einen Längsseite des Streifens 5 wegstehen. Wesentlich hierbei ist auch, daß die Anschlußdrähte 2 und 3 nach der Umgurtung durch die Vorrichtung jeweils eine genau vorgegebene Formgebung aufweisen. Die Befestigung der Bauelemente 1 bzw. deren Anschlußdrähte 2 und 3 an dem Streifen 5, der in gleichen Abständen mit Perforationslöchern 6 versehen ist, erfolgt beispielsweise mit Hilfe eines Klebebandes 7.

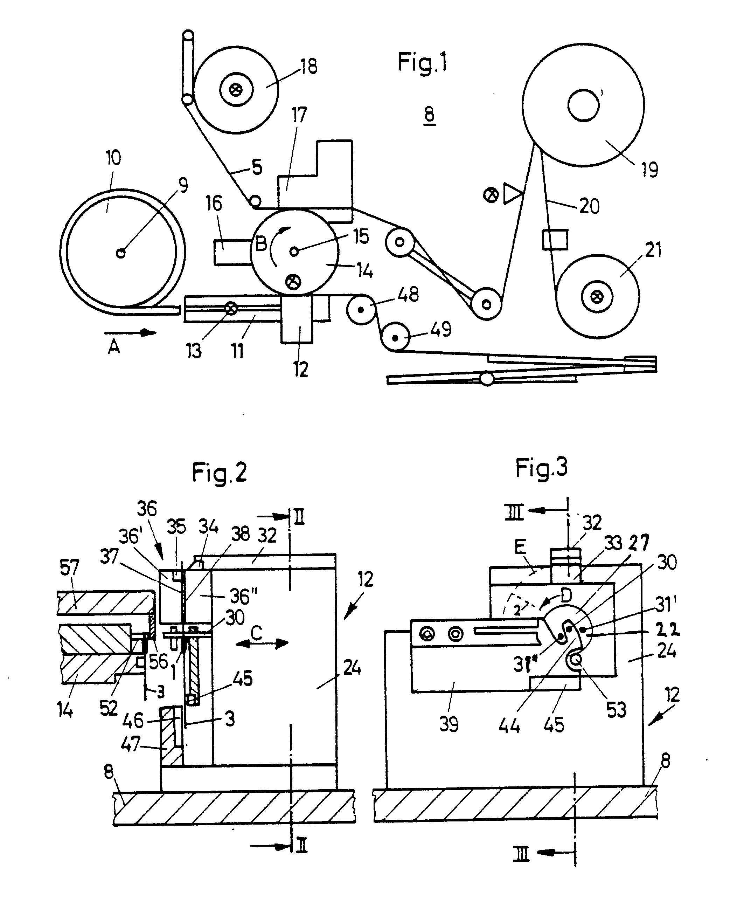

Bei der in den Fig. 1 - 10 dargestellten Vorrichtung ist auf der eine im wesentlichen horizontale Fläche bildenden Oberseite eines Maschinentisches 8 ein um eine vertikale Achse drehbarer und über diese Oberseite vorstehender Dorn 9 vorgesehen, auf welchen eine Spule 10 aufgesetzt werden kann, die die aufgegurteten Bauelemente 1 entsprechend Fig. 11 in aufgewickelter Form enthält. Von der Spule 10 werden die axial gegurteten Bauelemente 1 (gemäß Fig. 11) in Richtung des Pfeiles A abgezogen, wobei die einzelnen Bauelemente mit ihren Anschlußdrähten 2 und 3 senkrecht zu der Oberfläche des Maschinentisches 8, d.h. senkrecht zur Zeichenebene der Fig. 1 stehen.

Die von der Spule 10 zusammen mit der von den beiden Streifen 4 gebildeten Gurtung abgezogenen Bauelemente 1 werden über eine Führung 11 der ersten Arbeitsstation 12 zugeführt.

Im Bereich der Führung 11 sind Antriebsmittel 13 vorgesehen, die dafür sorgen, daß das Zuführen der aufgegurteten Bauelemente 1 an die Arbeitsstation 12 jeweils getaktet bzw. in einer intermittierenden Bewegung erfolgt, d.h. mit einer Bewegung, bei der sich an jedem Bewegungsschritt eine gewisse Stillstandszeit anschließt. Diese Mittel 13 werden beispielsweise von wenigstens einem Zahnrad gebildet, in welches die Anschlußdrähte 2 bzw. 3 der Bauelemente eingreifen und welches getaktet bzw. intermittierend von einem nicht näher dargestellten Antrieb angetrieben wird.

In der Arbeitsstation 12 wird zunächst der obere Anschlußdraht 2 jedes herangeführten Bauelementes 1 von dem oberen Streifen 4 abgetrennt. Im Anschluß daran erfolgt ein Umbiegen des Anschlußdrahtes 2 in der Weise, daß das freie Ende dieses Anschlußdrahtes nach unten gerichtet ist und in etwa parallel zum Anschlußdraht 3 liegt. Sobald dieses Umbiegen des Anschlußdrahtes 2 erfolgt ist, wird das Bauelement an den Transportteller 14 weitergegeben, wobei selbstverständlich dann auch das Abtrennen des Anschlußdrahtes 3 von dem unteren Streifen 4 erfolgt.

Der Transportstern 14 führt um eine vertikale, d. h. senkrecht zur Oberfläche des Maschinentisches 8 verlaufende Achse 15 in Richtung des Pfeiles B eine getaktete Bewegung aus, und zwar synchron zur Förderwirkung der Fördermittel 13, d. h. immer dann, wenn in der Arbeitsstation 12 ein Bauelement zur Übergabe an den Transportteller 14 bereitsteht, hat sich dieser zuvor um einen Arbeitsschritt weiterbewegt.

Der Transportteller 14 führt die an seinem Außenumfang gehaltenen Bauelemente zunächst an der zweiten Arbeitsstation 16 vorbei, in der die zunächst noch im wesentlichen geradlinigen Anschlußdrähte 2 und 3 ausgerichtet und in einer bestimmten, vorgegebenen Weise geformt werden. Bei der in den Figuren dargestellten Ausführungsform erfolgt diese Formung derart, daß der Anschlußdraht 2 eine in etwa dreieckförmige Auskragung aufweist und der Anschlußdraht 3 in einem Abschnitt in der Nähe des Bauelementes 1 im wesentlichen S-förmig gebogen ist, wobei die freien Enden der beiden Anschlußdrähte 2 und 3 parallel zueinander verlaufen.

Nach dieser Formgebung werden die Bauelemente 1 durch den umlaufenden Transportteller 14 schließlich einer dritten Arbeitsstation 17 zugeführt, in der die Bauelemente 1 dann entsprechend der Fig. 12 auf den Streifen 5 aufgegurtet werden. Zu diesem Zweck wird der Arbeitsstation 17 von einer Rolle 18 der Streifen 5 zugeführt. Die Arbeitsstation 17 erhält von einer weiteren, nicht näher dargestellten Rolle das Klebeband 7, mit dem die Bauelemente am Streifen 5 festgelegt werden.

Nach dem Aufgurten am Streifen 5 werden die Bauelemente 1 zusammen mit diesen Streifen auf eine Spule 19 aufgewickelt, die ebenso, wie die Spule 18 um eine vertikale Achse am Maschinentisch 8 drehbar gelagert ist.

Um zu vermeiden, daß sich die Bauelemente 1 verschiedener Lagen der Spule 19 gegenseitig verhaken, wird zusammen mit den aufgegurteten Bauelementen 1 auf der Spule 19 gleichzeitig eine streifenförmige Zwischenlage 20 mit aufgewickelt, die von einer Spule 21 abgezogen wird.

Die Fig. 2 bis 7 zeigen im einzelnen die erste Arbeitsstation 12 bzw. Teile hiervon.

Die erste Arbeitsstation 12 besteht im wesentlichen aus zwei Schlitten 22 und 23, die parallel zur Oberfläche des Maschinentisches 8 verschiebbar sind, und zwar jeweils radial zum Transportteller 14.

Beide Schlitten sind in einem Führungsklotz 24 geführt, der am Maschinentisch 8 befestigt ist und die Schlitten 22 und 23 so umschließt, daß diese nur die gewünschte Bewegung radial zum Transportteller 14 ausführen können. Der einfacheren Darstellung wegen ist der Führungsklotz 24 in den Figuren als ein einziges Teil dargestellt. Bei einer praktischen Ausführung der erfindungsgemäßen Vorrichtung kann dieser Führungsklotz jedoch auch aus mehreren Teilen zusammengesetzt sein.

Der ersten Schlitten 22 besitzt in Richtung radial zum Transportteller 40 eine durchgehende Bohrung 25, in der mit Hilfe von Kugellagern 26 eine Welle 27 um eine horizontale und radial zum Transportteller verlaufende Achse gelagert ist. An ihrem dem Transportteller 14 entfernt liegenden und über den Schlitten 22 vorstehenden Ende trägt die Welle 22 ein Zahnriemenrad 28, über welches die Welle 27 mit Hilfe eines Zahnriemens 29 und eines nicht näher dargestellten Antriebes zur Ausführung einer Drehbewegung um einen vorgegebenen Winkelbetrag angetrieben wird.

An ihrem dem Transportteller 14 zugewandten und mit der dortigen Fläche des Schlittens 22 fluchtenden Ende trägt die Welle 27 zwei Stifte 30 und 31, die frei von diesem Ende der Welle 27 wegstehen. Der Stift 30, der eine größere Länge als der Stift 31 aufweist, liegt achsgleich mit der Achse der Welle 27. Der Stift 31 liegt zwar parallel zur Achse der Welle 27, ist jedoch gegenüber der Achse der Welle 27 seitlich versetzt. Beide Stifte 30 und 31 haben in etwa den gleichen Querschnitt.

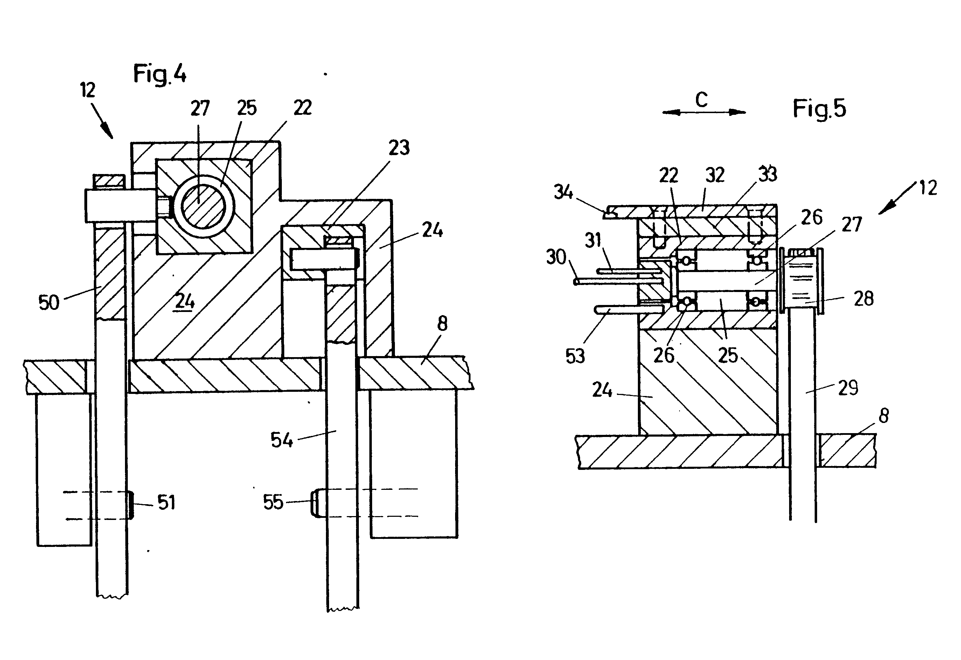

An der Oberseite trägt der Schlitten 22 ein Messer 32, welches über einen Distanzklotz 33 derart befestigt ist, daß dieses Messer über der oberen Fläche des Führungsklotzes 24 liegt bzw. auf der oberen Fläche des Führungsklotzes gleitet. Es versteht sich, daß für den Distanzklotz 33 eine schlitzförmige Ausnehmung im Führungsklotz 24 vorgesehen ist, so daß das Messer 32 zusammen mit dem Schlitten 22 radial zum Transportteller 14, d. h. in Richtung des Doppelpfeiles C der Fig. 2 und 5 bewegt werden kann.

Das Messer 32 besitzt an seinem dem Transportteller 14 benachbart liegenden Ende eine Schneide 34, der eine Gegenschneide 35 an einem ortsfesten Platinenelement 36 zugeordnet ist.

Dieses Platinenelemente 36 besteht im wesentlichen aus zwei Teilen 36' und 36'', die die Schenkelelemente einer klammer-oder gabelartigen Struktur bilden, d. h. das Teil 36', an dem die Gegenschneide 35 vorgesehen ist, besitzt an seiner dem Führungsklotz 24 zugewandten Seite eine ebene Fläche 37, der eine ebenfalls ebene Fläche 38 am Teil 36'' gegenüberliegt, so daß die Teile 36' und 36'' zwischen sich einen Kanal bilden, der seitlich von den genannten, senkrecht zur Oberfläche des Maschinentisches 8 verlaufenden Flächen 37 und 38 begrenzt ist. Die Breite dieses Kanales bzw. der Abstand der Flächen 37 und 38 ist in etwa gleich oder geringfügig größer als der Durchmesser des oberen Anschlußdrahtes 2. Wie insbesondere die Fig. 2 und 3 zeigen, ist dieser von den Flächen 37 und 38 seitlich begrenzte Kanal sowohl zur Unterseite als auch zur Oberseite hin offen, so daß die der Arbeitsstation 12 zugeführten und entsprechen der Fig. 11 aufgegurteten Bauelemente 1 mit dem oberen Ende der Anschlußdrähte 2 aus dem von den Flächen 37 und 38 gebildeten Kanal nach oben vorstehen und sich auch die obere Gurtung bzw. der obere Streifen 4 außerhalb des genannten Kanales befindet. Hierdurch ist es möglich, mit Hilfe der beiden Schneiden 34 und 35 den oberen Anschlußdraht 2 von dem oberen Streifen 2 abzutrennen, wobei der am oberen Streifen 4 gehaltene Teil des oberen Anschlußdrahtes an diesem Streifen verbleibt. An ihrem in der Fig. 3 linken Ende sind die beiden Teile 36' und 36'' miteinander und mit dem Führungsklotz 24 verbunden, wobei diese Verbindungsstelle in genügendem Abstand von der Achse der Welle 27 bzw. des Stiftes 30 angeordnet ist, so daß der von der oberen Gurtung bzw. von dem oberen Streifen 4 abgetrennte Anschlußdraht 2 in dem von den Flächen 37 und 38 gebildeten Kanal in Richtung des Pfeiles D der Fig. 3 umgebogen werden kann. Bei diesem Umbiegen beschreibt das nach dem Abtrennen freie Ende des Anschlußdrahtes 2 eine Kreisbogenbahn um den Stift 30, wie dies in der Fig. 3 mit der unterbrochenen Linie E angedeutet ist. Durch den von den Flächen 37 und 38 gebildeten Kanal wird verhindert, daß der Anschlußdraht 2 beim Umbiegen seitlich ausreichen kann. Es versteht sich, daß der erwähnte Kanal für die in die Arbeitsstation 12 einlaufenden Bauelemente 1, d. h. an der in der Fig. 3 rechten Seite offen ist.

An dem zweiten Schlitten 23, der ebenfalls in Richtung des Doppelpfeiles C im Führungsklotz 24 in horizontaler Richtung verschiebbar geführt ist, ist ein Einleger 39 befestigt, der ebenfalls als gabelförmiges oder klammerartiges Element ausgebildet ist und aus zwei plattenförmigen Teilen 39' und 39'' besteht. Der Teil 39' besitzt eine senkrecht zur Oberseite des Maschinentisches 8 verlaufende Fläche 40, der im Abstand eine ebenfalls senkrecht zur Oberfläche des Maschinentisches 8 verlaufende Fläche 41 am Teil 39'' im Abstand gegenüberliegt. Die beiden Flächen 40 und 41, die ebenso, wie die Flächen 37 und 38, senkrecht zur Bewegungsrichtung der Schlitten 23 und 22 liegen, bilden zwischen sich einen Kanal, der nach oben, nach unten sowie nach der Einlaufseite der Bauelemente 1, d.h. bei der für die Fig. 3 gewählten Darstellung nach der rechten Seite hin offen ist. Die Breite dieses von den Flächen 41 und 40 gebildeten Kanales ist gleich oder etwas größer als der Durchmesser der Bauelemente 1.

Wie insbesondere die Fig. 2 zeigt, liegt der Einleger 39 unterhalb des Platinenelementes 36 in der Weise, daß in der normalen Stellung bzw. in der Ruhestellung des Schlittens 23 bzw. des Einlegers 39 sich der von den Flächen 37 und 38 gebildete Kanal in dem von den Flächen 40 und 41 gebildeten Kanal nach unten hin fortsetzt. Die Teile 39' und 39'' des Einlegers 39 sind an ihrem in der Fig. 3 linken Ende miteinander und mit dem Schlitten 23 verbunden, wobei diese Verbindungsstelle bei der für die Fig. 3 gewählten Darstellung bezogen auf die Achse der Welle 27 bzw. des Stiftes 30 soweit nach links verlegt ist, daß sich beim Umbiegen des oberen Anschlußdrahtes 2 dieser mit seinem freien Ende auf der Kreisbahn E auf durch den von den Flächen 40 und 41 gebildeten Kanal hindurchbewegen kann.

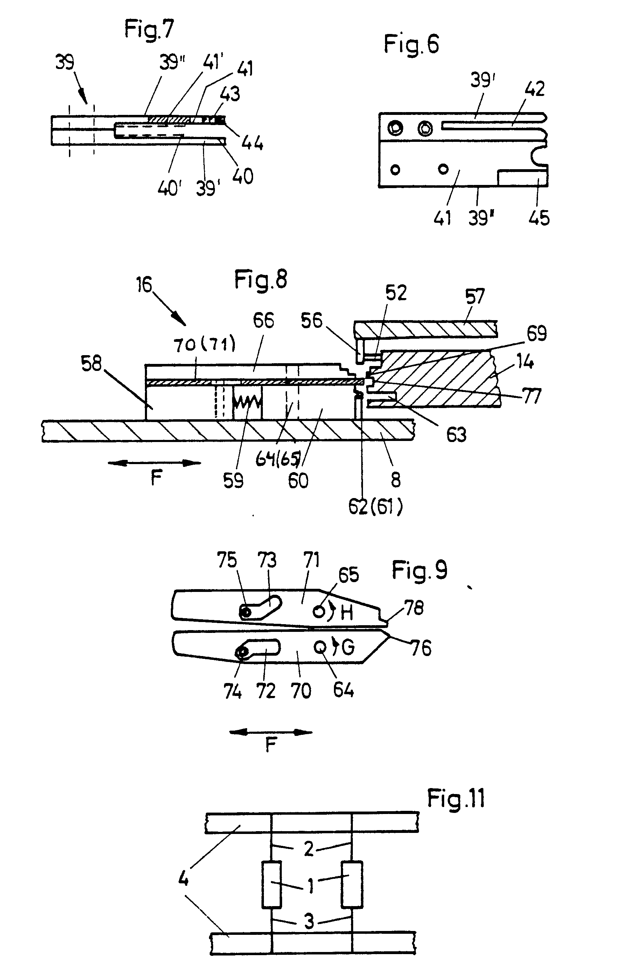

Um beim Biegen des Anschlußdrahtes 2 für diesen Anschlußdraht auch im Bereich des von den Flächen 40 und 41 gebildeten Kanals eine einwandfreie Führung zu erreichen, ist es vorteilhaft, die Fläche 40 und 41 stufenförmig derart auszubilden, daß dieser Kanal in seinem in der Fig. 3 linken Teilabschnitt nur noch eine Breite aufweist, die der Breite des von den Flächen 37 und 38 gebildeten Kanals entspricht, wie dies in der Fig. 7 mit unterbrochenen Linien angedeutet ist. Der Stufenabsatz 40' bzw. 41 der Flächen 40 bzw. 41 liegt dann vorzugweise unmittelbar in der Nähe des Stiftes 30 und kann dabei als zusätzliche Anlage für das betreffende Bauelement 1 dienen.

Wie insbesondere die Fig. 2, 6 und 7 zeigen, besitzt der Teil 39' eine von einem durchgehenden horizontalen Längsschlitz 42 gebildete Öffnung, wobei dieser Längsschlitz an seiner in der Fig. 3 rechten, d.h. dem Führungselement 11 zugewandten Seite offen ist. Der Teil 39'' besitzt eine von einer Bohrung 43 gebildete Öffnung. Durch beide Öffnungen 42 und 43 reicht der Sift 30 hindurch. Die Bohrung 43 ist in einer Öse 44 des Teiles 39'' vorgesehen. Durch diese Öse 44 kann der Stifte 31 beim Drehen der Welle 27 in Richtung des Pfeiles D der Fig. 3 eine Drehbewegung von mehr als 180°, d.h. beispielsweise eine Drehbewegung in der Größenordnung von 240° um die Bohrung 43 ausführen, und zwar aus der in der Fig. 3 rechten Position 31' in die in der Fig. 3 linke Position 31'', und zwar auch dann, wenn der Stift 31 mit seinem freien Ende in den von den Flächen 40 und 41 gebildeten Kanal hineinreicht. Das freie Ende des Stiftes 31 reicht dann in diesen Kanal hinein, wenn sich der Schlitten 22 in seiner Arbeitsstellung, d. h. in der dem Transportteller 14 benachbarten Stellung befindet.

An der unteren Längskante des dem Führungsklotz 24 benahbart liegenden Teiles 39'' ist unterhalb des Stiftes 30 eine Schneide 45 befestigt, der eine Gegenschneide 46 an einer ortsfesten Platine 47 zugeordnet ist. Mit den Schneiden 45 und 46 wird der in der Fig. 11 untere Anschlußdraht 3 von dem untern Streifen 4 bzw. von der unteren Gurtung abgetrennt.

Die Streifen 4 mit den an diesen Streifen verbleibenden Teilen der Anschlußdrähte 2 und 3 werden über Rollen 48 und 49 bei der für die Fig. 1 gewählten Darstellung von der Arbeitsstation 12 nach rechts abgeführt.

Die Arbeitsweise der Arbeitsstation 12 läßt sich, wie folgt, beschreiben:

Immer dann, wenn ein auf den Streifen 4 aufgegurtetes Bauelement 1 herangeführt wird, befinden sich die beiden Schlitten 22 und 23 in ihrer Ruhestellung, d. h. in einer Stellung, in der diese Schlitten den größten Abstand von dem Transportteller 14 aufweisen. Das herangeführte Bauelement 1 gelangt in den von den Flächen 40 und 41 des Einlegers 39 gebildeten Kanal, wobei der obere Anschlußdraht 2 (mit Ausnahme seines am Streifen 4 befestigten Endes) in dem von den Flächen 37 und 38 gebildeten Kanal zu liegen kommt. Der Stift 31 befindet sich mit seinem freien Ende, noch außerhalb des von den Flächen 40 und 41 gebildeten Kanales, während sich der Stift 30 bereits durch die Öffnungen 42 und 43 hindurcherstreckt und somit quer zu dem von den Flächen 40 und 41 gebildeten Kanal liegt. Das zugeführte Bauelement 1 liegt mit seinem oberen Anschlußdraht gegen diesen Stift 30 an, und zwar unmittelbar an der Übergangsstelle zwischen dem Anschlußdraht 2 und dem Bauelement 1.

Mit Hilfe eines Schwenkhebels 50, der über einen nicht näher dargestellten Antrieb um seine horizontale Schwenkachse 51 geschwenkt wird, wird zunächst der Schlitten 22 aus seiner Ruhestellung in die Arbeitsstellung geschwenkt, wodurch der Stift 31 mit seinem freien Ende in den von den Flächen 40 und 41 gebildeten Kanal eintritt. Der Stift 31 hat hierbei die in der Fig. 3 mit 31' bezeichnete Position. Durch das Bewegen des Schlittens 22 wird mit Hilfe des Messers 32 das obere Ende des Anschlußdrahtes 2 vom dortigen Streifen bzw. Gurt 4 abgetrennt. Nun wird mit Hilfe des Zahnriemens 29 die Welle 27 gedreht, und zwar in Richtung des Pfeiles D der Fig. 3. Hierdurch wird durch den Stift 31 der obere Anschlußdraht 2 mitgenommen und um den Stift 30 umgebogen. Die Drehbewegung der Welle 27 wird gestoppt, wenn der Stift 31 die in der Fig. 3 mit 31'' angegebene Position aufweist. Der obere Anschlußdraht 2 ist dann um 180° um den Stift 30 umgebogen.

Befindet sich der Schlitten 22 in seiner Arbeitsstellung, so berührt das freie Ende des Stiftes 30 stumpf das freie Ende eines Haltestiftes 52, der am Transportteller 14 vorgesehen ist und seitlich radial von diesem Transportteller wegsteht. Es versteht sich, daß am Transportteller 14 eine Vielzahl derartiger Haltestifte 52 vorgesehen sind, und zwar in einem gegenseitigen Abstand, der einem Taktschritt des Transporttellers 14 entspricht.

Um ein einwandfreies Biegen des oberen Anschlußdrahtes 2 zu gewährleisten, d. h. um ein Ausweichen des Bauelementes 1 beim Biegen des oberen Anschlußdrahtes 2 zu verhindern, ist am Schlitten 22 unterhalb der Welle 27 bzw. der Stifte 30 und 31 ein weiterer Stift 53 vorgesehen, der dann, wenn sich der Schlitten 22 in seiner Arbeitsposition befindet, ein Gegenlager für den unteren Anschlußdraht 3 bildet, d. h. gegen welchen der untere Anschlußdraht 3 beim Biegen des oberen Anschlußdrahtes 2 anliegt, und zwar ebenfalls unmittelbar an der Übergangsstelle zwischen diesem Anschlußdraht und dem Bauelement 1. Dadurch, daß die beiden Stifte 30 und 53 beim Biegen des oberen Anschlußdrahtes 2 an den Anschlußdrähten 2 bzw. 3 unmittelbar an der Übergangsstelle mit dem Bauelement 1 anliegen, wird nicht nur ein fester Halt für das Bauelement 1 während des Biegevorganges erreicht, sondern gleichzeitig durch den Stift 30 auch sichergestellt, daß bei jedem Bauelement 1 die Biegung des oberen Anschlußdrahtes 2 bezogen auf das Bauelement auf der jeweils gleichen Stelle erfolgt.

Nach dem Biegen des Anschlußdrahtes 2 wird mit Hilfe eines Schwenkhebels 54, der von einem nicht näher dargestellten Antrieb angetrieben wird und um den horizontalen Gelenkstift 55 schwenkbar ist, der Schlitten 23 aus seiner Ruhestellung in die Arbeitsstellung bewegt. Hierdurch bewegt sich der Einleger 39 in Richtung der Achse des Stiftes 30 bei der für die Fig. 2 gewählten Darstellung nach links, wodurch das Bauelement 1 mit dem umgebogenen Anschlußdraht 2 von dem Stift 30 auf den Haltestift 52 aufgeschoben wird und somit hängend an dem Haltestift 52 des Transporttellers 14 gehalten ist. Eine den Transportteller 14 im Bereich der Haltestifte 52 umgebende ringförmige Führungsbahn 56, die an einem ortsfesten, tellerartigen Teil 57 befestigt ist, verhindert, daß die an die Haltestifte 52 übergebenen Bauelemente 1 von diesen Haltestiften während des Drehens des Transporttellers 14 seitlich herunterrutschen können. Es versteht sich, daß die Führungsbahn 56 im Bereich der Arbeitsstation 12, d. h. in dem Bereich, in dem die Übergabe der Bauelemente an den Transportteller 14 erfolgt, auf einer kurzen Länge unterbrochen ist.

Die Arbeitsstation 16 zum Formen der Anschlußdrähte 2 und 3 besitzt einen Antriebsklotz 58, der durch nicht näher dargestellte Mittel in Richtung des Doppelpfeiles F der Fig. 8 in horizontaler Richtung und radial zum Transportteller 14 hin-und herbewegbar ist. Der Antriebsklotz 58 wirkt über eine Druckfeder 59 auf einen ebenfalls in Richtung des Doppelpfeiles F auf der Oberseite des Maschinentisches 8 verschiebbar geführten Führungsklotz 60 ein.

Der Führungsklotz 60 besitzt an seinem dem Transportteller 14 zugewandten Ende zwei Vorsprünge 61 und 62, die einen gegenseitigen Abstand voneinander aufweisen, welchem dem Abstand entspricht, den die freien Enden der Anschlußdrähte 2 und 3 nach dem Aufgurten auf dem Streifen 5 voneinander besitzten sollen. Sobald der Führungsklotz 60 durch den Antriebsklotz 58 in seine Arbeitsstellung, d. h. in seine dem Transportteller am nächsten liegende Position verschoben ist, reichen die Vorsprünge 61 und 62 in eine ringförmige Umfangsnut 63 hinein, die im Transportteller 14 unterhalb der Haltestifte 52 vorgesehen ist.

Mit dem Führungsklotz 60 ist über zwei Gelenkstifte 64 und 65 eine Einspannplatte 66 verbunden, die an ihrem den Transportteller 14 zugewandten Ende zwei Vorsprünge 67 und 68 aufweist. Diese Vorsprünge haben einen Abstand voneinander, der in etwa gleich dem Durchmesser des Anschlußdrahtes 3 ist, so daß der Anschlußdraht 3 zwischen den beiden Vorsprüngen 67 und 68 gehalten ist, wenn sich der Führungsklotz in der Arbeitsstellung befindet und die beiden Vorsprünge 67 und 68 gegen die Umfangsfläche bzw. gegen einen zylinderförmigen Teil 69 der Umfangsfläche des Transporttellers 14 anliegen. Dieser zylinderförmige Teil 69 liegt unterhalb der Haltestifte 52 sowie unterhalb von halbkreisförmigen Aufnahmetaschen, die im Transportteller 14 zur Aufnahme der Bauelemente 1 vorgesehen sind und von denen jeweils eine jedem Haltestück 52 zugeordnet ist.

An jedem vertikalen Gelenkstift 64 und 65 ist zwischen der Einspannplatte 66 und dem Führungsklotz 60 ein Biege- bzw. Zangenelemente 70 bzw. 71 schwenkbar gelagert, wobei jedes Zangenelement eine eine Kulissenführung bildende Öffnung 72 bzw. 73 aufweist, in die von unten her ein Stift 74 bzw. 75 hineinreicht. Die beiden Stifte 74 und 75 sind im Antriebsklotz 58 befestigt.

Die Arbeitsweise der Arbeitsstation 16 läßt sich, wie folgt, erläutern:

Sobald der Transportteller 14 ein Bauelement 1 an die Arbeitsstation 16 herangeführt hat, wird während der Stillstandszeit des Transporttellers 14 der Antriebsklotz 58 bei der für die Fig. 8 gewählten Darstellung nach rechts bewegt, wodurch über die Druckfeder 59, den Führungsklotz 60 und die Gelenkstifte 64 und 65 die Vorsprünge 67 und 68 der Einspannplatte 66 gegen den zylinderförmigen Teil 69 des Transporttellers 14 zur Anlage kommen und das betreffende Bauelement am Anschlußdraht 3 festlegen. Die Vorsprünge 61 und 62 reichen dann in die Nut 63 hinein.

Die Bewegung des Führungsklotzes 60 und der mit diesem Führungsklotz verbundenen Elemente in Richtung des Doppelpfeiles F nach rechts ist abgeschlossen, sobald die Vorsprünge 67 und 68 an dem zylinderförmigen Teil 69 anliegen.

Bei einer weiteren Bewegung des Antriebsklotzes 58 nach rechts, was aufgrund der Druckfeder 59 möglich ist, bewegen sich die Stifte 74 und 75 in den Öffnungen 72 und 73. Da die schlitzförmige Öffnung 73 an ihrem in der Fig. 9 linken Ende im wesentlichen in Richtung der Bewegung des Antriebsklotzes 58 verläuft, hat diese weitere Bewegung des Antriebsklotzes 58 zunächst keinen Einfluß auf das mit der Öffnung 73 versehene Zangenelement 71.

Die Öffnung 72 im Zangenelement 70 erstreckt sich jedoch an ihrem in der Fig. 9 linken Ende schräg zur Bewegungsrichtung des Antriebsklotzes 58, so daß dieses Zangenelement bei der weiteren Bewegung des Antriebsklotzes 58 um den Gelenkstift 64 bei der für die Fig. 9 gewählten Darstellung im Gegenuhrzeigersinn, d. h. in Richtung des Pfeiles G geschwenkt wird. Ein an dem Zangenelement 70 vorgesehener Vorsprung 76, der bei in Arbeitsstellung befindlichem Führungsklotz 60 in eine Nut 77 des Transporttellers 14 hineinragt, biegt den Anschlußdraht 2 bei der für die Fig. 10 gewählten Darstellung nach links. Da die gegen den Anschlußdraht 2 anliegende Kante des Vorsprunges 76 dreieckförmig ausgebildet ist und da der Anschlußdraht 2 an seiner dem Vorsprung 76 abgewandten Seite zugleich gegen eine schräge Kante 68' des Vorsprunges 68 sowie gegen einen ebenfalls in die Nut 77 hineinragenden Vorsprung 78 am Zangenelement 71 anliegt, wird durch die Schwenkbewegung des Zangenelementes 70 um den Gelenkstift 64 in den Anschlußdraht 2 die eingangs bereits erwähnte dreieckförmige Auskragung 2' eingedrückt. Bei dieser Formgebung ist das in der Fig. 10 untere Ende des Anschlußdrahtes 2 zwischen dem Vorsprung 58 und dem Vorsprung 62 geführt bzw. gehalten.

Die Formgebung für den Anschlußdraht 2 ist abgeschlossen, sobald der Stift 74 in den Teil der Öffnung 72 eingetreten ist, der parallel zur Bewegungsrichtung des Antriebsklotzes 58 verläuft. In diesem Augenblick tritt der Stift 75 in den Teil der Öffnung 73 ein, der schräg zur Bewegungsrichtung des Klotzes 58 liegt, wodurch das Zangenelement 71 bei der für die Fig. 9 gewählten Darstellung ebenfalls im Gegenuhrzeigersinn um den Gelenkstift 65 geschwenkt wird, d. h. in Richtung des Pfeiles H. Die den Vorsprung 76 entfernt liegende Seite des Vorsprunges 78 erfaßt nun den Anschlußdraht 3 und drückt diesen Anschlußdraht bei der für die Fig. 10 gewählten Darstellung nach links, wobei der Anschlußdraht 3 einerseits gegen den Vorsprung 67 und andererseits gegen den Vorsprung 61 anliegt, so daß die oben erwähnte S-förmige Verformung des Anschlußdrahtes 3 im Bereich 3' erhalten wird.

Im Anschluß daran bewegt sich der Antriebsklotz 58 wieder in seine Ruhestellung, d. h. bei der für die Fig. 8 gewählten Darstellung nach links, wodurch zunächst die Zangenelemente 70 und 71 in ihre Ausgangsstellung zurückschwenken und dann der Führungsklotz 60 sowie die Einspannplatte 66 das betreffende Bauelement am Transportteller 14 freigeben. Der Transportteller 14 kann sich dann um einen weiteren Taktschritt weiterbewegen und die Anschlußdrähte 2 und 3 eines weiteren, herangeführten Bauelementes 1 können in der beschriebenen Weise gebogen bzw. geformt werden.

Die Übergabe und Befestigung der Bauelemente 1 in der Arbeitsstation 17 an den Streifen 5 bzw. an diesem Streifen erfolgt mit üblichen, bekannten Mitteln, die nicht Gegenstand der vorliegenden Erfindung sind.

Die Erfindung wurde voranstehend an einem Ausführungsbeispiel beschrieben. Es versteht sich, daß Änderungen sowie Abwandlungen möglich sind, ohne daß dadurch der der Erfindung zugrundeliegende Gedanke verlassen wird.

**Patentansprüche**

1. Vorrichtung zum Umgurten von axial gegurteten elektrischen Bauelementen in quasi-radial gegurtete Bauelemente, dadurch gekennzeichnet,

daß an einem Maschinengestell (8) eine erste ortsfest angeordnete Arbeitsstation (12) zum Zuführen der axial gegurteten Bauelemente (1) und zum Umbiegen wenigstens eines Anschlußdrahtes (2) dieser Bauelemente (1) vorgesehen ist, an der (Arbeitsstation) ein Transportelement, vorzugsweise ein Dreh- bzw. Transportteller (14), schrittweise vorbeibewegt wird, welches bzw. welcher Aufnahmen (52) für die Bauelemente (1) besitzt,

daß die erste Arbeitsstation (12) einen vorzugsweise nur an einem Ende gehaltenen Biegedorn oder ersten Stift (30) aufweist, dessen Achse in etwa parallel zu einer vorzugsweise horizontalen und quer zur Bewegungsrichtung (B) des Transportelementes (14) bzw. der Aufnahmen (52) verlaufenden Raumachse (C) liegt und der vorzugsweise mit wenigstens einem Teil einer Umfangsfläche eine Fortsetzung einer Fläche der Aufnahmen (52) bildet,

daß an der ersten Arbeitsstation (12) um eine Achse parallel zur erwähnten Raumachse (C) ein Träger (27) schwenkbar bzw. drehbar gelagert ist, der an einer dem Transportelement (14) zugewendeten Seite ein vorstehendes und gegenüber dem Biegedorn (30) versetztes Biegeelement (31) trägt, welches eine Gegenfläche zum Biegen bildet,

daß an der ersten Arbeitsstation (12) ein Einleger (39) vorgesehen ist, welcher eine dem Transportelement (14) zugewendete Anlagefläche (41) für die Bauelemente (1) bildet, über die (Anlagefläche) der Biegedorn (30) mit seinem einen Ende vorsteht,

daß der Einleger (39) in Richtung der erwähnten Raumachse (C) aus einer ersten, dem Transportelement (14) bzw. den Aufnahmen (52) entfernt liegenden Ruhestellung in eine dem Transportelement (14) bzw. den Aufnahmen (52) benachbart liegende Arbeitsstellung verschiebbar ist, und

daß an der ersten Arbeitsstation (12) Mittel, z. B. Messerelemente (34, 35; 45, 46) zum Abtrennen der axial gegurteten Bauelemente (1) von der Gurtung (4) vorgesehen sind.

2. Vorrichtung nach Anspruch 1, dadurch gekennzeichnet, daß der erwähnte, vorzugsweise von einer Welle gebildete Träger (27) an einem ersten Schlitten (22) schwenkbar bzw. drehbar gelagert ist, welcher (erste Schlitten) in Richtung der erwähnten Raumachse (C) verschiebbar ist, und daß vorzugsweise der Biegedorn (30) ebenfalls am Träger befestigt ist, und zwar achsgleich mit der Dreh- bzw. Schwenkachse dieses Trägers (27).

3. Vorrichtung nach Anspruch 1 oder 2, dadurch gekennzeichnet, daß das erwähnte Biegeelement (31) in Richtung der erwähnten Raumachse (C) eine solche Abmessung aufweist und in Richtung dieser Raumachse derart bewegbar ist, daß bei in Ruhestellung befindlichem Einleger (39) das Biegeelement in einer Ruhestellung nicht über die erwähnte Anlagefläche (41) vorsteht und in einer Arbeitsstellung über diese Anlagefläche (41) vorsteht.

4. Vorrichtung nach einem der Ansprüche 1 bis 3, dadurch gekennzeichnet, daß der erwähnte Einleger (39) an einem zweiten Schlitten (23) befestigt ist, welcher in Richtung der erwähnten Raumachse (C) bewegbar ist.

5. Vorrichtung nach einem der Ansprüche 1 bis 4, dadurch gekennzeichnet, daß der Einleger (39) ein die Anlagefläche (41) bildendes, vorzugsweise plattenförmiges erstes Teil (39'') aufweist, daß in diesem ersten Teil (39'') eine Bohrung (43) vorgesehen ist, durch die der erste Stift (30) hindurchreicht, und daß vorzugsweise der Einleger (39) im Abstand von dem ersten Teil (39'') ein vorzugsweise plattenförmiges zweites Teil (39') besitzt, wobei in diesem zweiten Teil (39') eine schlitzförmige, zu einem Ende hin offene Öffnung (42) vorgesehen ist, deren Längserstreckung in Bewegungsrichtung des Transportelementes (14) liegt, und wobei die beiden plattenförmigen Teile (39', 39'') im Einleger (39) einen Kanal bilden, der sich im wesentlichen senkrecht zu der erwähnten Raumachse (C) erstreckt.

6. Vorrichtung nach einem der Ansprüche 2 bis 5, dadurch gekennzeichnet, daß am ersten Schlitten ein vorzugsweise stiftförmiges Anlageelement (53) für den anderen Anschlußdraht (3) jedes Bauelementes (1) vorgesehen ist, und daß dieses Anlageelement (53) in Richtung der erwähnten Raumachse (C) eine solche Abmessung aufweist, daß das Anlageelement (53) über die Anlagefläche (41) vorsteht, wenn sich der ersten Schlitten (22) in seiner Arbeitsstellung befindet.

7. Vorrichtung nach einem der Ansprüche 1 bis 6, dadurch gekennzeichnet, daß senkrecht zu der erwähnten Raumachse (C) gegenüber dem Einleger (39) versetzt ein vorzugsweise ortsfestes Platinenelement (36) angeordnet ist, welches einen Kanal mit seitlichen Begrenzungsflächen (37, 38) aufweist, die senkrecht zu der erwähnten Raumachse (C) bzw. senkrecht zur Achse des ersten Stiftes (30) liegen.

8. Vorrichtung nach einem der Ansprüche 2 bis 7, dadurch gekennzeichnet, daß zur Bildung der Mittel zum Abtrennen der axial gegurteten Bauelemente (1) am ersten Schlitten (22) im Abstand vom Biegedorn (30) ein Messer (32) mit einer Schneide (34) befestigt ist, welcher (Schneide) eine ortsfeste Gegenschneide (35) zugeordnet ist, und daß vorzugsweise am zweiten Schlitten (23), beispielsweise an dem am zweiten Schlitten (23) befestigten Einleger (39) ein zweites Messer mit einer Schneide (45) befestigt ist, und zwar ebenfalls im Abstand vom ersten Stift (30) und an der der Schneide (34) des ersten Messers (32) gegenüberliegenden Seite des ersten Stiftes (30), wobei der Schneide (45) des zweiten Messers eine ortsfeste Gegenschneide (46) zugeordnet ist.

9. Vorrichtung nach einem der Ansprüche 1 bis 8, dadurch gekennzeichnet, daß am Maschinengestell (8) eine zweite Arbeitsstation (16) vorgesehen ist, an der das Transportelement (14) ebenfalls schrittweise vorbeibewegt wird, und daß die zweite Arbeitsstation (16) einen dritten Schieber oder Schlitten (60), der quer zur Bewegungsrichtung (B) des Transportelementes (14) aus einer Ruhestellung in eine Arbeitsstellung am Maschinengestll bewegbar ist, sowie wenigstens ein Biegewerkzeug (70, 71) mit einer, z. B. von einem ersten Vorsprung (76, 78) gebildeten Formfläche aufweist, die in Richtung quer zur Verschiebungsrichtung (F) dieses dritten Schlittens (60) bewegbar ist.

10. Vorrichtung nach Anspruch 9, dadurch gekennzeichnet, daß das Biegewerkzeug (70, 71) mit Hilfe wenigstens eines Gelenkstiftes (64, 65) am dritten Schlitten (60) angelenkt ist, daß der dritte Schlitten (60) über wenigstens ein Federelement, vorzugsweise über wenigstens eine Druckfeder (59) mit einem verschiebbaren Antriebselement (58) in Verbindung steht, daß im Antriebselement (58) wenigstens ein Stift (74, 75) vorgesehen ist, der in eine Kulissenführung bzw. in eine eine Kulissenführung bildende Öffnung (72, 73) des Biegewerkzeugs (70, 71) eingreift, und daß vorzugsweise das Antriebselement (58) für den dritten Schlitten (60) in der gleichen Richtung (F) wie dieser Schlitten (60) verschiebbar ist, und daß die die Kulissenführung bildende Öffnung (72, 73) wenigstens in einem Teilbereich schräg zur Verschiebungsrichtung (F) des dritten Schlittens (60) verläuft.

11. Vorrichtung nach Anspruch 10, dadurch gekennzeichnet, daß am dritten Schlitten (60) wenigstens zwei Biegewerkzeuge (70, 71) schwenkbar gehaltert sind, und daß die als Kulissenführung dienende Öffnung (72) in dem einen Biegewerkzeug (70) in Richtung von ihrem einen zu ihrem anderen Ende hin einen schräg zur Verschiebungsrichtung (F) des dritten Schlittens (60) verlaufenden Abschnitt und einen darauffolgenden parallel zu dieser Verschiebungsrichtung (F) verlaufenden Abschnitt aufweist, und daß bei der als Kulissenführung dienenden Öffnung (73) des anderen Biegewerkzeugs (71) in der gleichen Richtung auf einen parallel zur Verschiebungsrichtung (F) verlaufenden Abschnitt ein schräg zur Verschiebungsrichtung (F) verlaufender Abschnitt folgt, wobei die schräg zur Verschiebungsrichtung (F) verlaufenden Abschnitte der beiden Öffnungen (72, 73) vorzugsweise in etwa parallel zueinander liegen.

12. Vorrichtung nach einem der Ansprüche 9 bis 11, dadurch gekennzeichnet, daß am dritten Schlitten (60) wenigstens eine von mindestens einem zweiten Vorsprung (61, 62, 67, 68) gebildete Gegenfläche vorgesehen ist, und daß vorzugsweise jeweils beidseitig von der Formfläche (76, 78) eine von einem zweiten Vorsprung (61, 62, 67, 68) gebildete Gegenfläche vorgesehen ist, wobei vorzugsweise bei zwei Biegewerkzeugen (70, 71) der die Formfläche des einen Biegewerkzeugs (71) bildende Vorsprung (78) zugleich eine der Formfläche (76) des anderen Biegewerkzeugs (70) zugeordnete Gegenfläche bildet.

## Claims

1. Device for rebelting axially belted electrical components into virtually radially belted components, characterized in that a first fixed work station (12) for feeding the axially belted components (1) and for bending over at least one lead (2) of these components (1) is provided on a machine frame (8), past which work station a transporting element, preferably a rotary or transporting table (14), which has receptacles (52) for the components (1), is gradually moved, that the first work station (12) has a bending mandrel or first pin (30) which is preferably held only at one end and whose axis lies approximately parallel to a preferably horizontal spatial axis (C) running transversely to the direction of movement (B) of the transporting element (14) or the receptacles (52) and which, preferably with at least a

part of a peripheral surface, forms an extension of a surface of the receptacles (52), that a support (27) is pivotably or rotatably mounted at the first work station (12) about an axis parallel to the said spatial axis (C), which support (27), at a side facing the transporting element (14) supports a protruding bending element (31) which is offset relative to the bending mandrel (30) and forms a counter-surface for bending, that provided at the first work station (12) is an inserter (39) which forms for the components (1) an abutment surface (41) which faces the transporting element (14) and beyond which the bending mandrel (30), with its one end, protrudes, that the inserter (39) is displaceable in the direction of the said spatial axis (C) from a first inoperative position, remote from the transporting element (14) or the receptacles (52), into a working position adjacent to the transporting element (14) or the receptacles (52), and that means, e.g. knife elements (34, 35; 45, 46), are provided at the first work station (12) for cutting off the axially belted components (1) from the belt (4).

2. Device according to claim 1, characterised in that the said support (27), preferably formed by a shaft, is pivotably or rotatably mounted on a first slide (22) which is displaceable in the direction of the said spatial axis (C), and that the bending mandrel (30) is preferably likewise fixed to the support, and in fact on the same axis as the rotational or pivot axis of this support (27).

3. Device according to claim 1 or 2, characterised in that the said bending element (31) is of such dimensions in the direction of the said spatial axis (C) and is movable in the direction of this spatial axis in such a way that, when the inserter (39) is in the inoperative position, the bending element does not protrude beyond the said abutment surface (41) in an inoperative position and protrudes beyond this abutment surface (41) in a working position.

4. Device according to any of claims 1 to 3, characterised in that the said inserter (39) is fixed to a second slide (23) which is movable in the direction of the said spatial axis (C).

5. Device according to any of claims 1 to 4, characterised in that the inserter (39) has a preferably plate-shaped first part (39″) forming the abutment surface (41, that provided in this first part (39″) is a bore (43) through which the first pin (30) passes, and that the inserter (39), at a distance from the first part (39″), preferably has a plate-shaped second part (39′), a slotted opening (42) open towards one end being provided in this second part (39′), the longitudinal extent of which opening (42) lies in the direction of movement of the transporting element (14), and the two plate-shaped parts (39′, 39″) forming in the inserter (39) a channel which essentially extends perpendicularly to the said spatial axis (C).

6. Device according to any of claims 2 to 5, characterised in that a preferably pin-shaped abutment element (53) for the other lead (3) of each component (1) is provided on the first slide, and that this abutment element (53) is of such dimensions in the direction of the said spatial axis (C) that the abutment element (53) protrudes beyond the abutment surface (41) when the first slide (22) is in its working position.

7. Device according to any of claims 1 to 6, characterised in that, offset relative to the inserter (39), a preferably fixed flat-bar element (36) is arranged perpendicularly to the said spatial axis (C), which flat-bar element (36) has a channel with lateral boundary surfaces (37, 38) which lie perpendicularly to the said spatial axis (C) or perpendicularly to the axis of the first pin (30).

8. Device according to any of claims 2 to 7, characterised in that, to form the means for cutting off the axially belted components (1), a knife (32) having a blade (34) is fixed to the first slide (22) at a distance from the bending mandrel (30), which blade has allocated to it a fixed counter-blade (35), and that a second knife having a blade (45) is fixed preferably to the second slide (23), for example to the inserter (39) fixed to the second slide (23), and in fact likewise at a distance from the first pin (30) and at the side of the first pin (30) opposite the blade (34) of the first knife (32), a fixed counter-blade (46) being allocated to the blade (45) of the second knife.

9. Device according to any of claims 1 to 8, characterised in that provided on the machine frame (8) is a second work station (16) past which the transporting element (14) is likewise gradually moved, and that the second work station (16) has a third sliding member or slide (60), which is movable on the machine frame transversely to the direction of movement (B) of the transporting element (14) from an inoperative position into a working position, and also at least one bending tool (70, 71) having a shaping surface which is formed, e.g. , by a first projection (76, 78) and is movable transversely to the displacement direction (F) of this third slide (60).

10. Device according to claim 9, characterised in that the bending tool (70, 71) is articulated on the third slide (60) by means of at least one hinge pin (64, 65), that the third slide (60) is connected to a displaceable drive element (58) via at least one spring element, preferably via at least one compression spring (59) that provided in the drive element (58) is at least one pin (74, 75) which engages into a slotted, link guide or into an opening (72, 73) of the bending tool (70, 71) forming a slotted-link guide, and that the drive element (58) for the third slide (60) is preferably displaceable in the same direction (F) as this slide (60), and that the opening (72, 73) forming the slotted-link guide, at least in a sectional area, runs at an angle to the displacement direction (F) of the third slide (60).

11. Device according to claim 10, characterised in that at least two bending tools (70, 71) are pivotably mounted on the third slide (60), and that the opening (72) serving as a slotted-link guide, in one bending tool (70), in the direction from its one end to its other end, has a section running at an angle to the displacement direction (F) of the third slide (60) and a following section running parallel to this displacement direction (F), and that in the opening (73), serving as a slotted-link guide, of the other bending tool (71), a section running at an angle to the displacement direction (F) follows, in the same direction, a section running parallel to the displacement direction (F), the sections of the two openings (72, 73) running at an angle to the displacement direction (F) preferably lying approximately parallel to one another.

12. Device according to any of claims 9 to 11, characterised in that at least one counter-surface formed by at least one second projection (61, 62, 67, 68) is provided on the third slide (60), and that a counter-surface formed by a second projection (61, 62, 67, 68) is preferably provided in each case on both sides of the shaping surface (76, 78), wherein, in the case of two bending tools (70, 71), the projection (78) forming the shaping surface of one bending tool (71) preferably forms at the same time a counter-surface allocated to the shaping surface (76) of the other bending tool (70).

## Revendications

1. Dispositif permettant de modifier la présentation sur bande de composants électriques à présentation sur bande du type axial de façon à donner des composants électriques à présentation sur bande de type quasi-radial, caractérisé en ce qu'il est prévu, sur un bâti de machine (8), un premier poste de travail (12) à emplacement fixe, servant à amener les composants (1) à présentation sur bande de type axial et à replier au moins une sortie (2) de ces composants (1), poste de travail devant lequel est deplacé pas-à-pas un élément de transport, de préférence un plateau rotatif ou de transport (14), qui possède des logements (52) pour les composants (1), en ce que ce premier poste de travail (12) comporte un mandrin de pliage ou première tige (30) qui est maintenu, de préférence uniquement à une extrémité dont l'axe est disposé de manière sensiblement parallèle à un axe géométrique (C) de préférence horizontal et s'étendant transversalement à la direction de déplacement (B) de l'élément de transport (14) ou des logements (52) et qui, de préférence, forme, avec au moins une partie de sa surface cylindrique, un prolongement d'une surface des logements (52),

en ce qu'un support (27) est monté basculant ou rotatif sur le premier poste de travail (12) autour d'un axe parallèle audit axe géométrique (C), ce support (27) portant, sur une face tournée vers l'élément de transport (14), un élément de pliage (31) en saillie qui est décalé par rapport au mandrin de pliage (30) et formant une surface de contre-appui pour le pliage,

en ce qu'il est prévu, sur le premier poste de travail (12), une pièce d'insertion (39) qui présente, pour les composants (1), une surface d'appui (41) qui est tournée vers l'élément de transport (14) et par rapport à laquelle le mandrin de pliage (30) fait saillie par son extrémité,

en ce que la pièce d'insertion (39) peut être déplacée en translation, suivant la direction dudit axe géométrique (C), d'une première position de repos, située à distance de l'élément de transport (14) ou des logements (52), à une position de travail située au voisinage dudit élément de transport (14) ou des logements (52),

et en ce qu'il est prévu, sur le premier poste de travail (12), des moyens, par exemple des éléments de couteau (34, 35; 45, 46), permettant de séparer de la bande (4) les composants à présentation sur bande de type axial (1).

2. Dispositif suivant la revendication 1, caractérisé en ce que le support (27), constitué de préférence par un arbre, est monté basculant ou rotatif sur un premier chariot (22), lequel premier chariot peut être déplacé en translation suivant la direction de l'axe géométrique (C), et en ce que, de préférence, le mandrin de pliage (30) est aussi fixé sur le support, et ceci suivant un axe coïncidant avec l'axe de rotation ou basculement dudit support (27).

3. Dispositif suivant la revendication 1 ou 2, caractérisé en ce que l'élément de pliage (31) est mobile et présente, suivant la direction de l'axe géométrique (C), une dimension appropriée, de telle façon que, lorsque la pièce d'insertion (39) se trouve en position de repos, ledit élément de pliage ne fait pas saillie par rapport à la surface d'appui (41) lorsqu'il est dans une position de repos et fait saillie par rapport à cette surface d'appui (41) lorsqu'il est dans une position de travail.

4. Dispositif suivant l'une des revendications 1 à 3, caractérisé en ce que la pièce d'insertion (39) est fixée sur un deuxième chariot (23) qui est mobile suivant la direction de l'axe géométrique (C).

5. Dispositif suivant l'une des revendications 1 à 4, caractérisé en ce que la pièce d'insertion (39) comprend une première partie (39''), de préférence en forme de plaque, constituant la surface d'appui (41), en ce qu'il est prévu, dans cette première partie (39''), un peçage (43) que traverse la première tige (30) et en ce que, de préférence, la pièce d'insertion (39), comporte à distance de la première partie (39''), une seconde partie (39'), de préférence en forme de plaque, dans laquelle il est ménagé une ouverture (42) en forme de fente et ouverte à une extrémité et dont la dimension la plus allongée s'étend suivant la direction de déplacement de l'élément de transport (14), les deux parties en forme de plaque (39', 39'') formant dans la pièce d'insertion (39) un canal qui s'étend de manière sensiblement perpendiculaire à l'axe géométrique (C).

6. Dispositif suivant l'une des revendications 1 à 5, caractérisé en ce que, sur le premier chariot, il est prévu un élément d'appui (53), de préférence en forme de tige, destiné à l'autre sortie (3) de chaque composant (1), et en ce que cet élément d'appui (53) présente, suivant la direction de l'axe géométrique (C), une dimension telle que l'élément d'appui (53) se trouve au-dessus de la surface d'appui (41) lorsque le premier chariot (22) est en position de travail.

7. Dispositif selon l'une des revendications 1 à 6, caractérisé en ce qu'un élément de platine (36), de préférence fixe, est disposé perpendiculairement à l'axe géométrique (C), en étant décalé par rapport à la pièce d'insertion (39), l'élément de platine (36) comportant un canal à surfaces latérales de limitation (37, 38) qui sont disposées perpendiculairement à l'axe géométrique (C) ou perpendiculairement à l'axe de la première tige (30).

8. Dispositif suivant l'une des revendications 2 à 7, caractérisé en ce que, pour constituer les moyens de séparation des composants (1) à présentation sur bande de type axial (1), un couteau (32) est fixé sur le premier chariot (22) à distance du mandrin de pliage (30), ce couteau (32) possédant une arête de coupe (34) à laquelle est associée une contre-arête de coupe (35) fixe, et en ce qu'un second couteau, comportant une arête de coupe (45), est fixé de préférence sur le deuxième chariot (23), par exemple sur la pièce d'insertion (39) fixée sur ce deuxième chariot (23), et ce également à distance de la première tige (30) et du côté de cette première tige (30) qui est situé à l'opposé de l'arête de coupe (34) du premier couteau (32), une contre-arête de coupe (46) fixe étant associée à l'arête de coupe (45) du second couteau.

9. Dispositif suivant l'une des revendications 1 à 8, caractérisé en ce qu'il est prévu, sur le bâti de machine (8), un second poste de travail (16) devant lequel passe également pas-à-pas l'élément de transport (14) et en ce que ce second poste de travail (16) comprend un troisième tiroir ou chariot (60) qui peut être déplacé sur le bâti de machine, transversalement à la direction de déplacement (B) de l'élément de transport (14), d'une position de repos jusque dans une position de travail, ainsi qu'au moins un outil de pliage (70, 71) comportant une surface de conformation, par exemple formée par une première saillie (76, 78), qui est mobile suivant une direction transversale à la direction de déplacement en translation (F) de ce troisième chariot (60).

10. Dispositif suivant la revendication 9, caractérisé en ce que l'outil de pliage (70, 71) est articulé sur le troisième chariot (60) à l'aide d'au moins un tourillon (64, 65), en ce que le troisième chariot (60) est relié à un élément d'entraînement (58), mobile en translation, par l'intermédiaire d'au moins un élément élastique, de préférence par l'intermédiaire d'au moins un ressort de compression (59), en ce qu'il est prévu, dans l'élément d'entraînement (58), au moins un téton (74, 75) qui s'engage dans une glissière de guidage ou dans une ouverture (72, 73) de l'outil de pliage (70, 71) formant une glissière de guidage, en ce que, de préférence, l'élément d'entraînement (58) prévu pour le troisième chariot (60) peut être déplacé en translation suivant la même direction (F) que ce chariot (60) et en ce que l'ouverture (72, 73) formant la glissière de guidage s'étend, au moins sur une zone partielle, de façon inclinée par rapport à la direction de déplacement en translation (F) du troisième chariot (60).

11. Dispositif suivant la revendication 10, caractérisé en ce qu'au moins deux outils de pliage (70, 71) sont montés basculants sur le troisième chariot (60), en ce que l'ouverture (72) servant de glissière de guidage et ménagée dans l'un (70) de ces outils de pliage comprend, suivant la direction allant de l'une à l'autre de ses extrémités, une section s'étendant de façon inclinée par rapport à la direction de déplacement en translation (F) du troisième chariot (60) et, s'y raccordant, une section s'étendant parallèlement à cette direction de déplacement en translation (F) et en ce que, en ce qui concerne l'ouverture (73), servant de glissière de guidage, de l'autre outil de pliage (71) et suivant la même direction, une section s'étendant de façon inclinée par rapport à la direction de déplacement en translation (F) est disposée à la suite d'une section s'étendant parallèlement à cette direction de déplacement en translation (F), les sections des deux ouvertures (72, 73) qui s'étendent de façon inclinée par rapport à la direction de déplacement en translation (F) étant de préférence disposées de manière sensiblement parallèles l'une à l'autre.

12. Dispositif suivant l'une des revendications 9 à 11, caractérisé en ce qu'il est prévu sur le troisième chariot (60) au moins une surface de contre-appui formée d'au moins une seconde saillie (61, 62, 67, 68), et en ce qu'il est de préférence prévu de part et d'autre de chaque surface de conformation (76, 78) une surface de contre-appui formée d'une seconde saillie (61, 62, 67, 68), tandis que, de préférence, dans le cas de deux outils de pliage (70, 71), la saillie (78) formant la surface de conformation de l'un (71) des outils de pliage, constitue en même temps une surface de contre-appui associée à la surface de conformation (76) de l'autre outil le pliage (70).

Fig.1

Fig.2

Fig.3

1

Fig.5

Fig.4

## Fig.7

## Fig.6

## Fig.8

## Fig.9

## Fig.11

## Fig.10

## Fig.12

EP 0 081 668 B1